# EUROPÄISCHE PATENTSCHRIFT

(11) **EP 3 610 277 B1**
(45) Veröffentlichungstag und Bekanntmachung des Hinweises auf die Patenterteilung: **25.01.2023**
(21) Anmeldenummer: 18709549.2
(22) Anmeldetag: 06.03.2018
(51) Int. Cl.: G01R 31/36

(54) **SYSTEM UND VERFAHREN ZUM BESTIMMEN EINES ZUSTANDS EINER FAHRZEUGBATTERIE**
SYSTEM AND METHOD FOR DETERMINING A STATUS OF A VEHICLE BATTERY
SYSTÈME ET PROCÉDÉ PERMETTANT DE DÉTERMINER UN ÉTAT D'UNE BATTERIE DE VÉHICULE

(30) Priorität: 10.04.2017 DE 102017206071
(43) Veröffentlichungstag der Anmeldung: 19.02.2020
(73) Patentinhaber: Robert Bosch GmbH, 70442 Stuttgart (DE)
(72) Erfinder: GUPTA, Sanghmitra, 70567 Stuttgart (DE)
(86) Internationale Anmeldenummer: PCT/EP2018/055477
(87) Internationale Veröffentlichungsnummer: WO 2018/188857

(56) Entgegenhaltungen:
- DE-A1-102007 061 130
- DE-A1-102013 205 692
- DE-T5- 10 297 252
- DE-T5- 10 393 251
- DE-T5-112009 001 806
- JP-A- 2013 191 281
- JP-B2- 5 028 376
- US-A1- 2016 231 388

## Beschreibung

Die vorliegende Erfindung betrifft ein System sowie ein Verfahren zum Bestimmen eines Zustands einer Fahrzeugbatterie eines Fahrzeugs, insbesondere einer Startfähigkeit der Batterie des Fahrzeugs. Beim Fahrzeug kann es sich insbesondere um einen Lastkraftwagen oder einen Personenkraftwagen handeln. Die Fahrzeugbatterie kann insbesondere eine Start/Stopp-Automatik-Batterie sein.

### Stand der Technik

Eine Fahrzeugbatterie, welche auch als Autobatterie oder Starterbatterie bezeichnet wird, ist üblicherweise ein Akkumulator, welcher unter anderem die elektrische Energie für einen Anlasser eines Verbrennungsmotors liefern kann. Der Verbrennungsmotor kann ein Verbrennungsmotor eines rein durch den Verbrennungsmotor angetriebenen Fahrzeugs sein. Alternativ kann der Verbrennungsmotor auch ein Zusatzmotor eines auch teilweise elektrisch angetriebenen Fahrzeugs sein, d. h., eines Hybridfahrzeugs.

Im Laufe der Zeit entladen sich Fahrzeugbatterien, sei es aufgrund von physikalischen oder chemischen Vorgängen, aufgrund von Ruheverbrauchern des Fahrzeugs wie zum Beispiel einer Diebstahlsicherung, oder einer Standheizung, oder aufgrund von anderen Effekten. Daher besteht die Gefahr, dass ein abgestelltes Fahrzeug nach einer gewissen Standzeit nicht mehr gestartet werden kann. Mit anderen Worten kann es dazu kommen, dass die Fahrzeugbatterie keine Startfähigkeit mehr aufweist und somit das Fahrzeug nicht mehr startfähig ist.

In der DE 10 317 524 A1 sind ein Verfahren und eine Vorrichtung zur Vorhersage der Startfähigkeit eines Fahrzeugs beschrieben, welche basierend auf einem Entladestrom bei abgestelltem Fahrzeug bestimmt wird.

Bekannt sind außerdem Telematikeinheiten. In der WO 2015/136029 A3 ist eine zur Nachrüstung in einem Fahrzeug beispielsweise mittels einer OBD2-Schnittstelle vorgesehene Telematikeinheit beschrieben, die mittels einer Konfigurationmodalität der Telematikeinheit für eine fahrzeugtypspezifische Kommunikation über wenigstens einen Fahrzeugbus des Fahrzeugs konfiguriert oder konfigurierbar ist. Weiterhin ist darin ein Telematiksystem zur Erfassung von Fahrzeugdaten des wenigstens einen Fahrzeugs durch ein drahtloses Kommunikationsnetz beschrieben.

Die DE 10 2007 061130 A1 offenbart eine Zustandsprüfung einer Fahrzeugbatterie.

Die DE 11 2009 001806 T5 offenbart ein Verfahren zum Bestimmen, dass der Ladezustand (SOC, state of charge) einer Fahrzeugbatterie zu niedrig sein könnte, um das Fahrzeug beim nächsten Fahrzeugstart zu starten.

Die DE 10 2013 205692 A1 offenbart eine Überwachung eines Zustands einer Batterie mittels fester Schwellwerte.

Die DE 103 93 251 T5 offenbart das Testen des Zustandes von Akkumulatorbatterien, die von der Batterietemperatur und dem Entladungszustand der Batterie abhängig sind.

Eine Aufgabe der vorliegenden Erfindung ist es, ein noch weiter verbessertes System sowie ein Verfahren zum Bestimmen des Zustands der Fahrzeugbatterie bereitzustellen.

### Offenbarung der Erfindung

Die vorliegende Erfindung offenbart ein System mit den Merkmalen des Patentanspruchs 1 sowie ein Verfahren mit den Merkmalen des Patentanspruchs 9.

Dementsprechend wird ein System zum Bestimmen eines aktuellen und/oder prognostizierten Zustands einer Fahrzeugbatterie eines Fahrzeugs bereitgestellt, mit:
einer Erfassungsvorrichtung, mittels welcher ein aktueller Spannungswert einer Spannung an Bord des Fahrzeugs, welche auf die Fahrzeugbatterie des Fahrzeugs zurückgeht, erfassbar ist; wobei die Erfassungsvorrichtung dazu eingerichtet ist, mehrmals einen jeweils aktuellen Ruhezustand-Spannungswert während mindestens eines Ruhezustands des Fahrzeugs zu erfassen, wenn eine vorbestimmte Ruhezustandsbedingung erfüllt ist; wobei in dem Ruhezustand des Fahrzeugs ein Motor des Fahrzeugs ausgeschaltet ist; einer Datenspeichervorrichtung, in welcher mindestens ein Spannungsschwellwert hinterlegt sind;
einer Anpassungsvorrichtung, welche dazu ausgelegt ist, basierend auf den erfassten Ruhezustand-Spannungswerten den mindestens einen Spannungsschwellwert in der Datenspeichervorrichtung anzupassen, wobei nur solche der erfassten Ruhezustand-Spannungswerte zur Berechnung der Spannungsschwellwerte berücksichtigt werden, welche eine vorbestimmte Verwertungsbedingung erfüllen; und einer Rechenvorrichtung, welche dazu ausgelegt ist, basierend auf einem Vergleich eines bereitgestellten Vergleichs-Spannungswert mit zumindest dem mindestens einen Spannungsschwellwert den aktuellen oder prognostizierten Zustand der Fahrzeugbatterie zu bestimmen und ein Ausgabesignal auszugeben, welches den bestimmten aktuellen und/oder prognostizierten Zustand der Fahrzeugbatterie indiziert.

Die Erfassungsvorrichtung ist bevorzugt eine mit einer OBD-Schnittstelle des Fahrzeugs verbundene Telematikeinheit oder Teil einer solchen Telematikeinheit. Die Telematikeinheit kann beispielsweise ausgebildet sein wie in der WO 2015/136029 A3 beschrieben.

Soweit hier und im Folgenden von einem Spannungswert die Rede ist, soll darunter stets verstanden werden, dass es sich um einen Spannungswert der Spannung an Bord des Fahrzeugs handelt, welche auf die Fahrzeugbatterie des Fahrzeugs zurückgeht. Bei dieser Spannung kann es sich insbesondere um eine Bordnetzspannung oder eine Klemmenspannung der Fahrzeugbatterie handeln. Die Fahrzeugbatterie ist bevorzugt eine Fahrzeugbatterie mit einer Nominalspannung von 12 Volt. Die Bordnetzspannung kann beispielsweise von einem Bordcomputer ausgegeben und erfasst werden, z.B. als ein CAN-Wert oder ein OBD-II-Standard-Diagnosewert wie etwa PID 42. Die Bordnetzspannung kann auch durch Messen an dem Fahrzeug (z.B. am Kabelbaum oder einer OBD-Pin) erfasst werden.

Darunter, dass ein erfasster Spannungswert die Verwertungsbedingung erfüllt, soll verstanden werden, dass der numerische Spannungswert selbst und/oder die Umstände, in welchen der Spannungswert erfasst wurde, z.B. der Zeitpunkt, an welchem der Spannungswert erfasst wurde, die Verwertungsbedingung erfüllen. Das Verwenden der Verwertungsbedingung bewirkt, dass nur solche erfasste Spannungswerte berücksichtigt werden, bei welchen eine hohe Wahrscheinlichkeit besteht, dass die Fahrzeugbatterie zuvor vollständig geladen wurde.

Weiterhin wird ein Verfahren zum Bestimmen eines aktuellen und/oder prognostizierten Zustands einer Fahrzeugbatterie eines Fahrzeugs geschaffen, mit den Schritten: Bereitstellen mindestens eines Spannungsschwellwerts; Mehrmaliges Erfassen eines jeweils aktuellen Ruhezustand-Spannungswerts einer Spannung an Bord des Fahrzeugs, welche auf die Fahrzeugbatterie des Fahrzeugs zurückgeht, während mindestens eines Ruhezustands des Fahrzeugs, wenn eine vorbestimmte Ruhezustandsbedingung erfüllt ist, wobei in dem Ruhezustand des Fahrzeugs ein Motor des Fahrzeugs ausgeschaltet ist; Anpassen des Spannungsschwellwerts basierend auf den erfassten Ruhezustand-Spannungswerten, sowie optional auf dem Nutzungs- und/oder Fahrverhalten des Fahrzeugs und/oder auf Umgebungsfaktoren, wobei nur solche der erfassten Ruhezustand-Spannungswerte berücksichtigt werden, welche eine vorbestimmte Verwertungsbedingung erfüllen; Erfassen eines aktuellen Spannungswerts als Vergleichs-Spannungswert und/oder Vorhersagen eines Schätzungs-Spannungswerts als Vergleichs-Spannungswert; Vergleichen des Vergleichs-Spannungswerts zumindest mit dem mindestens einen Spannungsschwellwert; Bestimmen des aktuellen und/oder prognostizierten Zustands der Fahrzeugbatterie basierend auf einem Ergebnis des Vergleichens; und Ausgeben eines Ausgabesignals, welches den bestimmten aktuellen und/oder prognostizierten Zustand der Fahrzeugbatterie indiziert.

### Vorteile der Erfindung

Eine der vorliegenden Erfindung zugrunde liegende Erkenntnis besteht darin, dass ohne eine Verwendung von zusätzlichen Sensoren, lediglich basierend auf einer Spannung, zum Beispiel der Bordnetzspannung, der Zustand der Fahrzeugbatterie bestimmt werden kann. Besonders vorteilhaft werden dabei über einen bestimmten Zeitraum hinweg, z.B. einen Tag, das Nutzungs- und Fahrverhalten der Nutzer des Fahrzeugs und/oder Umgebungsfaktoren berücksichtigt, sodass Schwellwerte für das Bestimmen des Zustands der Fahrzeugbatterie dynamisch angepasst werden können. Zu dem Nutzungs- und Fahrverhalten gehören beispielsweise gefahrene Kilometer pro Fahrt, eine maximal erreichte Drehzahl und/oder Entladungszeiträume. Zu den Umgebungsfaktoren kann beispielsweise eine Umgebungstemperatur zählen.

Das System und das Verfahren zum Bestimmen des aktuellen oder prognostizierten Zustands der Fahrzeugbatterie sind besonders vielseitig einsetzbar, da eine Vielzahl von internen oder externen Geräten, beispielsweise mobile Endgeräte, mit der Erfassungsvorrichtung verbunden werden kann, um den aktuellen oder den prognostizierten Zustand der Fahrzeugbatterie zu bestimmen. In der beschriebenen Weise können zusätzliche Hardwarekomponenten vermieden werden, was den technischen Aufwand, eine nötige Prozessorleistung und/oder eine nötige Bearbeitungszeit verringern kann.

Das Anpassen der hinterlegten Spannungsschwellwerte basierend auf im Ruhezustand des Fahrzeugs bei erfüllter Ruhezustandsbedingung gemessenen Spannungswerten sowie optional einem Nutzungs- und/oder Fahrverhalten des Fahrzeugs und/oder Umgebungsfaktoren, bei erfüllter Verwertungsbedingungen, ermöglicht eine fortlaufend präzisere und genauere Bestimmung des Fahrzeugzustands, welche auf ein konkretes Fahrzeug mit einer konkreten Fahrzeugbatterie abgestimmt sein kann. Dabei können Techniken des maschinellen Lernens (engl. "machine-based learning") eingesetzt werden. Durch das Anwenden der Verwertungsbedingung wird erreicht, dass das Anpassen der hinterlegten Spannungsschwellwerte nur auf solchen Messungen von aktuellen Spannungswerten basiert, welche besonders aussagekräftig und zuverlässig sind. Zum Beispiel zur Berechnung eines gleitenden Durchschnitts, spezifisch für das Fahrzeug, basierend auf Ruhespannungswerten, wobei die Fahrzeugbatterie mit hoher Wahrscheinlichkeit voll geladen ist, um darauf basierend den Zustand der Fahrzeugbatterie zu bestimmen, ermöglicht dies eine statistisch besonders belastbare und von äußeren Einflüssen möglichst unabhängige Bestimmung des Zustands der Fahrzeugbatterie

Das Erfassen der Spannungswerte im Ruhezustand des Fahrzeugs trägt ebenfalls zu einer besonders genauen Bestimmung des Zustands der Fahrzeugbatterie bei. In dem Ruhezustand des Fahrzeugs ist die Wahrscheinlichkeit besonders hoch, dass die Batterie ihre Ruhespannung erreicht hat.

Weitere Ausführungsformen und Weiterbildungen ergeben sich aus den Unteransprüchen sowie aus der Beschreibung unter Bezugnahme auf die Figuren.

Gemäß einer bevorzugten Weiterbildung ist die Erfassungsvorrichtung dazu ausgelegt oder eingerichtet, der Rechenvorrichtung einen aktuellen Spannungswert der Spannung an Bord des Fahrzeugs als den Vergleichs-Spannungswert bereitzustellen. In diesem Fall kann die Rechenvorrichtungen dazu ausgelegt oder eingerichtet sein, basierend auf dem Vergleich des als Vergleichs-Spannungswert bereitgestellten aktuellen Spannungswerts mit dem mindestens einen angepassten Spannungsschwellwert den aktuellen Zustand der Fahrzeugbatterie zu bestimmen und das Ausgabesignal derart zu erzeugen und auszugeben, dass dieses zumindest den bestimmten aktuellen Zustand der Fahrzeugbatterie indiziert. Somit kann, beispielsweise auf Anfrage eines Benutzers mittels eines Anfragesignals, der aktuelle Zustand der Fahrzeugbatterie bestimmt werden. Somit kann beispielsweise ein Benutzer des Fahrzeugs entscheiden, ob er dieses Fahrzeug jetzt verwenden möchte, oder ob er aufgrund der durch das Ausgabesignal als gering indizierten Startfähigkeit der Fahrzeugbatterie stattdessen eher ein anderes Fahrzeug wählen sollte bzw. durch externes Aufladen die Startfähigkeit herstellen möchte.

Gemäß einer weiteren bevorzugten Weiterbildung umfasst das System eine Schätzungsvorrichtung, welche dazu ausgelegt oder eingerichtet ist, mindestens einen zukünftigen Spannungswert der Spannung an Bord des Fahrzeugs als einen Schätzungs-Spannungswert zu schätzen oder vorherzusagen und den Schätzungs-Spannungswert der Rechenvorrichtung als Vergleichs-Spannungswert bereitzustellen. Bei dem Schätzungs-Spannungswert kann es sich um einen geschätzten aktuellen Spannungswert handeln, z.B. für den Fall, dass seit einer vorbestimmten Zeit kein aktueller Spannungswert an die Rechenvorrichtung übermittelt wurde bzw. zur Verfügung steht.

Alternativ oder zusätzlich kann der Schätzungs-Spannungswert auch ein prognostizierter Spannungswert, welcher auch als Prognose-Spannungswert bezeichenbar ist, sein, welcher eine Schätzung darstellt, wie der Spannungswert an einem zukünftigen Tag beschaffen sein dürfte. In diesem Fall kann die Rechenvorrichtung insbesondere dazu ausgelegt oder eingerichtet sein, basierend auf dem Vergleich des als Vergleichs-Spannungswert bereitgestellten Schätzungs-Spannungswerts mit dem zumindest einen angepassten Spannungsschwellwert zumindest den prognostizierten Zustand der Fahrzeugbatterie zu bestimmen und ein Ausgangssignal auszugeben, welches derart beschaffen ist, dass es zumindest den prognostizierten Zustand der Fahrzeugbatterie indiziert.

Der Schätzungs-Spannungswert kann zusätzlich basierend auf Umgebungsfaktoren erzeugt werden, etwa basierend auf einer aktuellen Jahreszeit oder einem aktuellen Datum, optional zusätzlich basierend auf einer Geoposition des Fahrzeugs. Zum Beispiel kann im Winter ein anderer Schätzungs-Spannungswert erzeugt werden als im Sommer, wobei durchschnittliche Temperaturen einfließen können. Dies kann besonders vorteilhaft in Regionen sein, in welchen üblicherweise große Temperaturunterschiede innerhalb eines Jahres auftreten, da der Spannungsabfall der Fahrzeugbatterie bei kalten Temperaturen steiler als bei warmen Temperaturen sein kann.

In den Schätzungs-Spannungswert können auch solche erfassten Spannungswerte eingehen, welche nicht die Verwertungsbedingung erfüllen. Solche Spannungswerte können insbesondere zur Ermittlung eines typischen Spannungsabfalls pro Zeitraum ohne Laden der Fahrzeugbatterie und/oder ohne Fahren des Fahrzeugs verwendet werden.

Auf diese Weise kann ein Benutzer beispielsweise eine Information darüber erhalten, ob, wenn das Fahrzeug weiterhin in einer bestehenden Situation geparkt bliebe, die Fahrzeugbatterie nach einer bestimmten Anzahl von Tagen noch eine Startfähigkeit aufweisen würde oder nicht. So kann der Benutzer beispielsweise entscheiden, ob er das Fahrzeug für einige Tage an einem bestimmten Ort abgestellt lassen kann oder abstellen kann, oder ob danach eine Gefahr besteht, dass die Fahrzeugbatterie keine Startfähigkeit mehr aufweist, d. h., sich nicht mehr starten lässt.

Gemäß einer weiteren bevorzugten Weiterbildung ist die Erfassungsvorrichtung an eine Diagnose-Schnittstelle, z.B. eine On-Board-Diagnose-(OBD-)-Schnittstelle, insbesondere eine OBD-2-Schnittstelle, des Fahrzeugs anschließbar oder angeschlossen und dazu eingerichtet, an der Diagnose-Schnittstelle eine aktuellen Spannungswert einer Bordnetzspannung des Fahrzeugs zu erfassen. Mit anderen Worten kann das mehrmalige Erfassen des jeweils aktuellen Ruhezustand-Spannungswerts an der Diagnose-Schnittstelle des Fahrzeugs erfolgen, wobei der mehrmals erfasste jeweils aktuelle Ruhezustand-Spannungswert ein Spannungswert der Bordnetzspannung des Fahrzeugs ist. Die Diagnose-Schnittstelle ist bevorzugt eine extern verfügbare Schnittstelle.

Alternativ oder zusätzlich kann die Erfassungsvorrichtung dazu eingerichtet sein, einen aktuellen Spannungswert einer Klemmenspannung der Fahrzeugbatterie direkt an Batteriepolen der Fahrzeugbatterie zu erfassen. Somit kann das mehrmalige Erfassen des jeweils aktuellen Ruhezustand-Spannungswerts an den Batteriepolen der Fahrzeugbatterie erfolgen und der Ruhezustand-Spannungswert kann ein jeweiliger Spannungswert der Klemmenspannung der Fahrzeugbatterie sein.

Gemäß einer weiteren bevorzugten Weiterbildung basiert das Ausgabesignal außerdem auf mindestens einer der folgenden Informationen:
- eine Information über einen Batterietyp der Fahrzeugbatterie;
- eine Information über einen Fahrzeugtyp des Fahrzeugs;
- eine Information über eine Historie des Fahrzeugs;
- eine Information über eine Ausstattung des Fahrzeugs.

Die Information über den Batterietyp der Fahrzeugbatterie kann beispielsweise umfassen, dass es sich bei der Fahrzeugbatterie um eine Li-lonen-Batterie oder um einen Bleiakkumulator (englisch "lead-acid battery") handeln, handelt, insbesondere um eine EFB-Batterie (englisch "enhanced flooded battery"), wahlweise auch eine AGM-Batterie (Absorbent Glass Mat). Eine AGM-Batterie ist eine verbesserte Fahrzeugbatterie für Kraftfahrzeuge mit Start-Stopp-System. Das Berücksichtigen der des Batterietyps der Fahrzeugbatterie kann eine genauere Vorhersage und/oder eine genauere Bestimmung des Zustands der Fahrzeugbatterie ermöglichen. Beispielsweise können durch das System zusätzliche Informationen ermittelt und bereitgestellt werden wie etwa, dass der Pegel einer Elektrolytflüssigkeit der Fahrzeugbatterie niedrig ist.

Die Information über den Fahrzeugtyp des Fahrzeugs kann beispielsweise eine Information umfassen, ob das Fahrzeug ein Kleinwagen, ein LKW oder ein SUV ist, was für einen Motor es aufweist, mit welchem Kraftstofftyp es fährt (z.B. Diesel oder Benzin) und dergleichen mehr. Basierend auf diesen Informationen kann ebenfalls ein präziseres Bestimmen des aktuellen und/oder des prognostizierten Zustands der Fahrzeugbatterie erfolgen.

Die Information über die Historie des Fahrzeugs kann insbesondere eine Information über eine Wartungshistorie und/oder eine Herstellungshistorie des Fahrzeugs umfassen. Beispielsweise kann das Jahr der Herstellung des Fahrzeugs, das Jahr des letzten Austauschs oder des Einbaus der Fahrzeugbatterie und dergleichen von der Information über die Historie des Fahrzeugs umfasst sein. Diese Informationen können dazu beitragen, eine genauere Bestimmung des aktuellen oder des prognostizierten Zustands der Fahrzeugbatterie zu ermöglichen. Beispielsweise kann berücksichtigt werden, dass es für eine Fahrzeugbatterie, welche mehr als 7 Jahre alt ist, wahrscheinlicher ist, dass Sulfatierung eintritt.

Unter einer Information über eine Ausstattung des Fahrzeugs ist beispielsweise eine Information über in dem Fahrzeug installierte technische Geräte zu verstehen, beispielsweise eine Sitzheizung, eine Standheizung, eine Diebstahlsicherung und dergleichen mehr. Weiterhin kann die Information über die Ausstattung des Fahrzeugs Informationen umfassen, welchen Energieverbrauch diese Geräte insbesondere im Ruhezustand des Fahrzeugs haben. Basierend auf diesen Informationen kann insbesondere eine präzisere Prognose des Zustands der Fahrzeugbatterie erfolgen.

Der aktuelle Ruhezustand-Spannungswert wird bevorzugt immer genau dann erfasst, sobald der Motor des Fahrzeugs ausgeschaltet ist und zusätzlich gleichzeitig eine vorbestimmte Ruhezustandsbedingung erfüllt ist. Durch die Ruhezustandsbedingung kann sichergestellt werden, oder eine Wahrscheinlichkeit erhöht werden, dass die Fahrzeugbatterie ihre Ruhespannung erreicht hat.

Die mindestens eine Ruhezustandsbedingung kann eine der folgenden Bedingungen aufweisen oder sein, oder eine Kombination von mindestens zwei der folgenden Bedingungen aufweisen oder sein:
- seit der letzten Fahrt mit dem Fahrzeug ist mindestens ein erster vorbestimmter Zeitraum, beispielsweise 6 Stunden, vergangen;
- eine vorbestimmte oder eingestellte Uhrzeit entspricht der aktuellen Uhrzeit;
- in einem zurückliegenden zweiten vorbestimmten Zeitraum, beispielsweise 24 Stunden, wurde kein Ruhezustand-Spannungswert erfasst.

Die Uhrzeit kann statisch festgelegt sein (z.B. 2 Uhr Nachts). Es kann auch vorgesehen sein, dass das System eine Geolokalisierungseinrichtung aufweist, welche eine aktuelle Geoposition des Fahrzeugs bereitstellt, und dass die Uhrzeit für das System dynamisch anhand der Geoposition und/oder anderer externer Faktoren festgelegt wird.

Gemäß einer weiteren vorteilhaften Weiterbildung kann die vorbestimmte Verwertungsbedingung eine der folgenden Bedingungen sein oder aufweisen, oder eine Verknüpfung von mindestens zwei der folgenden Bedingungen sein oder aufweisen:
- in einem zurückliegenden dritten vorbestimmten Zeitraum, beispielsweise 24 Stunden, wurde mindestens eine vorbestimmte Entfernung mit dem Fahrzeug zurückgelegt, beispielsweise mindestens 50 Kilometer, wobei festgelegt sein kann, dass gefahrene Kilometer mehrerer Fahrten zusammengezählt werden, oder dass nur jeweils innerhalb einer einzelnen Fahrt gefahrene Kilometer berücksichtigt werden;
- in einem zurückliegenden vierten vorbestimmten Zeitraum, z.B. 24 Stunden, vor dem Erfassen des Spannungswerts wurde innerhalb einer einzelnen Fahrt über mindestens einen fünften vorbestimmten Zeitraum, z.B. eine Stunde, auf einer Autobahn gefahren;
- in einem zurückliegenden sechsten vorbestimmten Zeitraum, z.B. 24 Stunden, vor dem Erfassen des Spannungswerts wurde innerhalb einer einzelnen Fahrt über mindestens einen siebten vorbestimmten Zeitraum, z.B. zwanzig Minuten, mit einer Drehzahl oberhalb eines vorbestimmten Drehzahl-Schwellenwerts, z.B. 3000 Umdrehungen pro Minute, gefahren.

Gemäß einer weiteren bevorzugten Weiterbildung umfasst das System ein mobiles und/oder internetfähiges Endgerät mit einer Ausgabevorrichtung, welche dazu ausgelegt ist, basierend auf dem Ausgabesignal eine grafische, akustische und/oder optische Ausgabe zu erzeugen. Das System kann derart ausgebildet sein, dass die Datenspeichervorrichtung, die Anpassungsvorrichtung und die Rechenvorrichtung in dem Fahrzeug installiert sind und dass das Ausgabesignal über eine drahtgebundene oder drahtlose Schnittstelle an das mobile Endgerät, bevorzugt an die Ausgabevorrichtung des mobilen Endgeräts übermittelt wird. Es kann auch vorgesehen sein, dass die Datenspeichervorrichtung, die Anpassungsvorrichtung und die Rechenvorrichtung in das mobile und/oder internet-fähige Endgerät (z.B. Computer, Smartphone oder Tablet) integriert sind. Weiterhin kann vorgesehen sein, dass eine oder einige der Datenspeichervorrichtung, Anpassungsvorrichtung, und Rechenvorrichtung in dem Fahrzeug integriert ist und eine oder einige der Datenspeichervorrichtung, Anpassungsvorrichtung, und Rechenvorrichtung in einem im Fahrzeug installierten Steuergerät integriert ist. Die Rechenvorrichtung und/oder die Anpassungsvorrichtung können auch cloudbasiert realisiert sein.

### KURZE BESCHREIBUNG DER ZEICHNUNGEN

Die vorliegende Erfindung wird nachfolgend anhand der in den schematischen Figuren der Zeichnungen dargestellten Ausführungsbeispiele näher erläutert. Es zeigen:
- Fig. 1: ein schematisches Blockdiagramm eines Systems zum Bestimmen eines Zustands einer Fahrzeugbatterie eines Fahrzeugs gemäß einer Ausführungsform der vorliegenden Erfindung;
- Fig. 2: ein schematisches Blockdiagramm eines Systems gemäß einer Variante des Systems aus Fig. 1;
- Fig. 3: ein schematisches Blockdiagramm eines Systems gemäß einer weiteren Variante des Systems aus Fig. 1; und
- Fig. 4: ein schematisches Flussdiagramm zum Erläutern einer weiteren Ausführungsform der vorliegenden Erfindung.

In allen Figuren sind gleiche bzw. funktionsgleiche Elemente und Vorrichtungen - sofern nichts anderes angegeben ist - mit denselben Bezugszeichen versehen.

### BESCHREIBUNG DER AUSFÜHRUNGSBEISPIELE

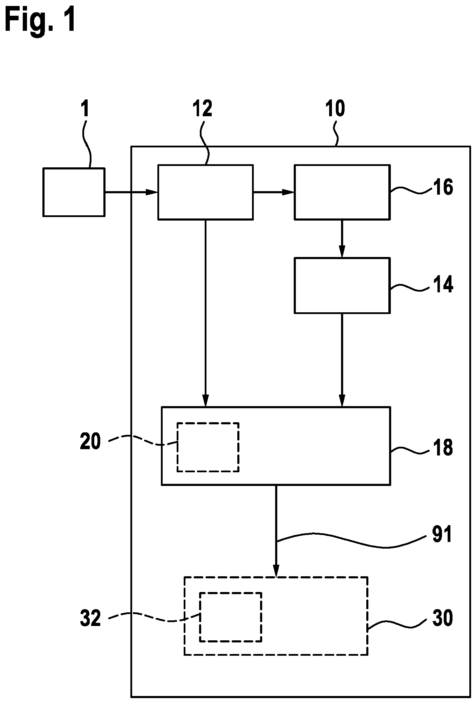

Fig. 1 zeigt ein schematisches Blockdiagramm eines Systems 10 zum Bestimmen eines Zustands einer Fahrzeugbatterie 1 eines Fahrzeugs gemäß einer Ausführungsform der vorliegenden Erfindung.

Das System 10 umfasst eine Erfassungsvorrichtung 12, mittels welcher ein aktueller Spannungswert einer Spannung an Bord des Fahrzeugs, welche auf die Fahrzeugbatterie 1 des Fahrzeugs zurückgeht, erfassbar ist. Bei dieser Spannung kann es sich insbesondere um eine Bordnetzspannung des Fahrzeugs handeln, welche durch die Erfassungsvorrichtung 12 beispielsweise an einer OBD-Schnittstelle des Fahrzeugs abgegriffen werden kann. Bei der Spannung kann es sich auch um eine Klemmenspannung handeln, welche durch die Erfassungsvorrichtung 12 an Batteriepolen der Fahrzeugbatterie 1 abgegriffen werden kann. Die Erfassungsvorrichtung 12 kann in dem Fahrzeug integriert oder integrierbar sein. Die Erfassungsvorrichtung 12 kann als eine in dem Fahrzeug installierte Telematikeinheit ausgebildet sein oder in einer solchen Telematikeinheit umfasst sein. Die Erfassungsvorrichtung 12 kann auch als ein Spannungsmesserschaltkreis ausgebildet sein.

Die Erfassungsvorrichtung 12 ist dazu eingerichtet, mehrmals einen jeweils aktuellen Ruhezustand-Spannungswert während mindestens eines Ruhezustands des Fahrzeugs zu erfassen, wobei in dem Ruhezustand des Fahrzeugs ein Motor des Fahrzeugs ausgeschaltet ist. Bevorzugt ist der Ruhezustand des Fahrzeugs ein Zustand, in welchem das Fahrzeug zudem abgestellt und durch den Benutzer nicht in Benutzung ist. In einem Ruhezustand des Fahrzeugs kann die Fahrzeugbatterie 1 ihre Ruhespannung erreichen, basierend auf welcher die präziseste Bestimmung des Zustands der Batterie, insbesondere ihrer Startfähigkeit, möglich ist. Üblicherweise benötigt eine typische Fahrzeugbatterie 1 etwa sechs Stunden, nachdem sie benutzt wurde, bevor sie wieder ihre Ruhespannung erreicht.

Die Erfassungsvorrichtung 12 ist dazu ausgebildet, den aktuellen Ruhezustand-Spannungswert immer genau dann zu erfassen, sobald der Motor des Fahrzeugs ausgeschaltet ist und zusätzlich mindestens eine vorbestimmte Ruhezustandsbedingung erfüllt ist. Bei der Ruhezustandsbedingung kann es sich insbesondere um eine der folgenden Bedingungen, oder um eine Kombination aus mindestens zwei der folgenden Bedingungen a) bis c) handeln:
a) Seit Ende der letzten Fahrt mit dem Fahrzeug (oder seit dem letzten Ausschalten des Motors des Fahrzeugs) ist mindestens ein erster vorbestimmter Zeitraum, beispielsweise 6 Stunden, vergangen. Dadurch wird sichergestellt, dass die Fahrzeugbatterie 1 ihre Ruhespannung erreicht hat. Die Erfassungsvorrichtung 12 kann dazu ausgelegt sein, ein Signal zu empfangen, welches indiziert, wieviel Zeit seit der letzten Fahrt mit dem Fahrzeug vergangen ist, beispielsweise über einen CAN-Bus des Fahrzeugs. Hierdurch wird die Wahrscheinlichkeit erhöht, dass die Fahrzeugbatterie 1 ihre Ruhespannung erreicht hat.
b) Eine vorbestimmte oder eingestellte Uhrzeit entspricht der aktuellen Uhrzeit. Die Erfassungsvorrichtung 12 kann dazu eine interne Uhr umfassen. Die vorbestimmte Uhrzeit kann beispielsweise zwischen 1 und 5 Uhr morgen liegen, etwa 2 Uhr morgens. Zu solchen Zeiten ist die Wahrscheinlichkeit besonders hoch, dass das Fahrzeug seit längerem nicht benutzt wurde und die Fahrzeugbatterie 1 somit Zeit hatte, ihre Ruhespannung zu erreichen. Die Uhrzeit, zu der Spannungswerte erfasst werden sollen, kann auch basierend auf Messungen auf eine Uhrzeit eingestellt werden, zu der das Fahrzeug in der Mehrzahl der Fälle, oder zu einer Wahrscheinlichkeit über einer vorbestimmten Mindestwahrscheinlichkeit, länger als einen weiteren vorbestimmten Zeitraum, z.B. länger als 6 Stunden, nicht gefahren wurde.
c) In einem zurückliegenden zweiten vorbestimmten Zeitraum, beispielsweise 24 Stunden, wurde kein Ruhezustand-Spannungswert erfasst. Durch diese Bedingung wird verhindert, dass innerhalb z.B. eines Tages mehrfach Messungen vorgenommen werden, sodass der Zustand der Fahrzeugbatterie 1 an diesem Tag mit übertriebener Gewichtung bei einer nachfolgenden Auswertung versehen wird.

Das System 10 umfasst außerdem eine Datenspeichervorrichtung 14, in welcher mindestens ein Spannungsschwellwert, bevorzugt mehrere Spannungsschwellwerte, hinterlegt sind. Die Datenspeichervorrichtung 14 kann in dem Fahrzeug integriert sein. Bevorzugt werden die Spannungsschwellwerte durch Analyse einer Vielzahl von Fahrzeugen über einen langen Zeitraum hinweg (z.B. dreihundert Fahrzeuge über ein Jahr hinweg) ermittelt, um Muster und statistische Modelle und Parameter wie einen Median, einen Mittelwert und einen Modalwert (häufigsten Wert) zu ermitteln. Basierend auf einem, mehreren oder allen dieser Parameter können die Spannungsschwellwerte festgelegt werden.

Beispielsweise kann, bei einer annähernd normalverteilten Spannungskurve der ermittelten Spannungen bei der Vielzahl der Fahrzeuge, eine Grenze für eine "gesunde" Fahrzeugbatterie 1 durch den Mittelwert gebildet werden. Eine Batterie in "kritischem Zustand" kann durch alle Werte zwischen dem Mittelwert und einem Wert bei "Mittelwert minus dreimal Standardabweichung)" charakterisiert sein. Durch eine solche dynamische Definition von Spannungsschwellwerten kann ein systematischer Messfehler vermieden werden, welcher z.B. in Telematikeinheiten vorliegen kann.

Das System 10 umfasst zudem eine Anpassungsvorrichtung 16, welche dazu ausgelegt ist, basierend auf den erfassten Ruhezustand-Spannungswerten den oder die Spannungsschwellwerte in der Datenspeichervorrichtung 14 anzupassen.

Dabei berücksichtigt die Anpassungsvorrichtung 16 nur solche erfassten Spannungswerte, welche eine vorbestimmte Verwertungsbedingung erfüllen. Die Verwertungsbedingung basiert bevorzugt auf dem Nutzungs- und Fahrverhalten des Fahrzeugs.

Bei Verwertungsbedingung kann es sich insbesondere um eine der folgenden Bedingungen, oder um eine Kombination aus mindestens zwei der folgenden Bedingungen d) bis f) handeln:
d) In einem zurückliegenden dritten vorbestimmten Zeitraum, beispielsweise 24 Stunden, wurde mindestens eine vorbestimmte Entfernung mit dem Fahrzeug zurückgelegt, beispielsweise mindestens 50 Kilometer. Hierdurch kann sichergestellt werden, oder die Wahrscheinlichkeit erhöht werden, dass die Fahrzeugbatterie 1 vollständig aufgeladen ist.
e) In einem zurückliegenden vierten vorbestimmten Zeitraum, z.B. 24 Stunden, vor dem Erfassen des Spannungswerts wurde innerhalb einer einzelnen Fahrt über mindestens einen fünften vorbestimmten Zeitraum, z.B. eine Stunde, auf einer Autobahn gefahren und/oder mit einer Geschwindigkeit oberhalb einem vorbestimmten Geschwindigkeitsschwellwert gefahren, z.B. oberhalb von 90 km/h, 100 km/h, 110 km/h oder 120 km/h. Hierzu können Navigationsdaten von einem Navigationsgerät und/oder einer Geolokalisierungseinrichtung und/oder einem Datenbus des Fahrzeugs an die Anpassungsvorrichtung übermittelt werden, wobei das Navigationsgerät und/oder die Geolokalisierungseinrichtung Teil des Systems 10 sein können.
f) In einem zurückliegenden sechsten vorbestimmten Zeitraum, z.B. 24 Stunden, vor dem Erfassen des Spannungswerts wurde innerhalb einer einzelnen Fahrt über mindestens einen siebten vorbestimmten Zeitraum, z.B. zwanzig Minuten, mit einer Drehzahl oberhalb eines vorbestimmten Drehzahl-Schwellenwerts, z.B. 3000 Umdrehungen pro Minute, gefahren.

Es kann vorkommen, dass Messwerte zu Zeitpunkten erfasst, z.B. gemessen, werden, zu welchen zwar die Ruhezustandsbedingung, aber nicht die Verwertungsbedingung erfüllt ist, wobei die zu solchen Zeitpunkten gemessenen Messwerte durch die weiteren Vorrichtungen des Systems 10 und/oder die weiteren Verfahrensschritte entsprechend nicht berücksichtigt werden. Alternativ kann auch vorgesehen sein, dass kein Erfassen, z.B. keine Messung, durchgeführt wird, wenn zwar die Ruhezustandsbedingung, aber nicht die Verwertungsbedingung erfüllt ist.

Die Anpassungsvorrichtung 16 kann in dem Fahrzeug integriert sein. Auf diese Weise kann einer für eine konkrete Fahrzeugbatterie 1 charakteristische Ruhespannung Rechnung getragen werden. Ist die Ruhespannung einer konkreten Fahrzeugbatterie 1 beispielsweise gegenüber einer Nominalspannung von z.B. 12 Volt abgesenkt, kann dies auf eine verringerte Startfähigkeit der Fahrzeugbatterie 1 hindeuten. Liegt dieser abgesenkte Wert knapp über einem der vorbestimmten Spannungsschwellwerte, könnte entsprechend häufig ein Warnsignal ausgegeben werden. Bevorzugt ist die Anpassungsvorrichtung 16 als Software realisiert, welche durch einen Prozessor ausführbar ist.

Bleibt dieser abgesenkte Wert der Ruhespannung bei dieser konkreten Fahrzeugbatterie 1 aber konstant über einen vorbestimmten vierten Zeitraum hinweg (z.B. über 2 Monate hinweg), so kann die Anpassungsvorrichtung 16 die Spannungsschwellwerte in der Datenspeichervorrichtung 14 anpassen, sodass der abgesenkte Wert der Ruhespannung an die Stelle der Nominalspannung von 12 Volt tritt und entsprechend alle Spannungsschwellwerte angepasst werden.

Die Anpassungsvorrichtung 16 kann derart ausgebildet sein, die Spannungsschwellwerte basierend auf einem gleitenden Durchschnitt der innerhalb der vorbestimmten Zeitspanne durch die Erfassungsvorrichtung 12 erfassten aktuellen Spannungswerte anzupassen, sobald eine vorbestimmte Zeitspanne verstrichen ist, beispielsweise als vorgegebene Prozentsätze des gleitenden Durchschnitts, welche größer und/oder kleiner als 100% sein können. Ein oder mehrere Spannungsschwellwerte können beispielsweise festgelegt werden als 120%, 100%, 100%, 95°, 90%, 85%, 80%, 60%, 50%, 40%, 20% und/oder 10% des gleitenden Durchschnitts. Ein Satz von Spannungsschwellwerten kann beispielsweise Spannungsschwellwerte in Höhe von 110%, 90% und 70%, oder in Höhe von 105%, 80% und 60% des gleitenden Durchschnitts umfassen. Wie im Vorstehenden erläutert, werden bei dem Bilden des gleitenden Durchschnitts nur die erfassten aktuellen Spannungswerteberücksichtigt, bei denen die Verwertungsbedingung erfüllt ist.

Das System 10 enthält weiterhin eine Rechenvorrichtung 18, welche dazu ausgelegt ist, basierend auf einem Vergleich eines bereitgestellten Vergleichs-Spannungswert mit den vordefinierten Spannungsschwellwerten und/oder mit den angepassten Spannungsschwellwerten den aktuellen oder prognostizierten Zustand der Fahrzeugbatterie 1 zu bestimmen und ein Ausgabesignal 91 auszugeben, welches den bestimmten aktuellen oder prognostizierten Zustand der Fahrzeugbatterie 1 indiziert. Die Rechenvorrichtung 18 kann in dem Fahrzeug integriert oder integrierbar sein.

Der Vergleichs-Spannungswert kann ein aktueller, durch die Erfassungsvorrichtung 12 erfasster Spannungswert sein. Dabei kann es sich beispielsweise um den jüngsten, gemäß dem oben stehenden Verfahren erfassten Spannungswert der mehreren während Ruhezuständen des Fahrzeugs erfassten Spannungswert handeln.

Das System 10 kann optional mit einer Schätzungsvorrichtung 20 ausgestattet sein, welche dazu ausgelegt ist, mindestens einen zukünftigen Spannungswert als einen Schätzungs-Spannungswert vorherzusagen und der Rechenvorrichtung 18 den vorhergesagten Schätzungs-Spannungswert als den Vergleichs-Spannungswert bereitzustellen. Die Schätzungsvorrichtung 20 kann als Teil der Rechenvorrichtung 18 ausgebildet sein.

Ein konkretes System 10 kann derart eingerichtet sein, dass lediglich die Erfassungsvorrichtung 12 den Vergleichs-Spannungswert bereitstellt, oder das System 10 kann die Schätzungsvorrichtung 20 aufweisen und derart eingerichtet sein, dass lediglich die Schätzungsvorrichtung 20 den Vergleichs-Spannungswert bereitstellt. Denkbar ist jedoch auch, dass ein konkretes System 10 so eingerichtet ist, dass es eine Schätzungsvorrichtung 20 aufweist und dass sowohl die Schätzungsvorrichtung 20 als auch die Erfassungsvorrichtung 12 dazu in der Lage sind, den Vergleichs-Spannungswert bereitzustellen. Die Schätzungsvorrichtung 20 kann insbesondere dann zum Bereitstellten des Vergleichs-Spannungswerts vorgesehen sein, wenn seit einem vorbestimmten zurückliegenden Zeitraum (z.B. 1 Tag, 2 Tage, 3 Tage oder mehr) kein aktueller Spannungswert an die Rechenvorrichtung 18 übermittelt wurde bzw. zur Verfügung steht.

Die Schätzungsvorrichtung 20 kann so ausgebildet sein, dass sie den Schätzungs-Spannungswert durch Subtrahieren eines Spannungsdifferenzwerts pro vorbestimmter vergangener Zeitspanne von dem letzten, durch die Rechenvorrichtung 18 empfangenen, aktuellen Spannungswert erzeugt oder, mit anderen Worten, schätzt. Beispielsweise kann vorgesehen sein, dass pro ganzem verstrichenem Tag (als vorbestimmte vergangene Zeitspanne) jeweils der Spannungsdifferenzwert abgezogen wird, wobei auch andere Zeitspannen möglich sind. Der Spannungsdifferenzwert kann einen festen Betrag aufweisen, beispielsweise zwischen 0.01 Volt und 0.03 Volt, bevorzugt 0.02 Volt.

Der Spannungsdifferenzwert kann auch ein dynamisch angepasster Spannungsdifferenzwert sein. Bevorzugt wird ein Spannungsdifferenzwert mit einem festen Betrag verwendet, bis ein dynamisch angepasster Spannungsdifferenzwert aufgrund einer ausreichenden Datenbasis (d.h. mit einer vorbestimmten Mindestanzahl von Datenpunkten) erzeugt wurde. Die Rechenvorrichtung 18 kann dazu eingerichtet sein, den Spannungsdifferenzwert aus Messdaten eines vorbestimmten zurückliegenden Zeitraums zu ermitteln, beispielsweise aus den Daten der letzten 14 Tage, der letzten 30 Tage oder dergleichen. Insbesondere kann vorgesehen sein, dass die Rechenvorrichtung 18 ermittelt, um welchen Spannungsdifferenzwert der aktuell gemessene Spannungswert sich jeweils innerhalb der vorbestimmten Zeitspanne (z.B. 1 Tag) verringert hat. Bevorzugt werden dabei nur solche Zeitspannen berücksichtigt, in welchen das Fahrzeug nicht gefahren wurde.

Das System 10 kann optional ein mobiles und/oder internet-fähiges Endgerät 30 aufweisen, welches eine Ausgabevorrichtung 32 umfasst. Das mobile Endgerät 30 ist bevorzugt ein Smartphone oder ein Computer. Die Ausgabevorrichtung 32 ist dazu ausgelegt oder eingerichtet, das Ausgabesignal 91 zu empfangen und basierend auf dem Ausgabesignal 91 eine grafische, akustische und/oder haptische Ausgabe zu erzeugen. Dementsprechend kann die Ausgabevorrichtung 32 einen Bildschirm (z.B. einen Touchscreen), einen Lautsprecher und/oder einen Vibrator aufweisen. Das System 10 kann weiterhin auch das Fahrzeug mit der Fahrzeugbatterie umfassen.

Die Datenspeichervorrichtung 14, die Anpassungsvorrichtung 16 und/oder die Rechenvorrichtung 18 können in dem mobilen Endgerät 30 integriert sein.

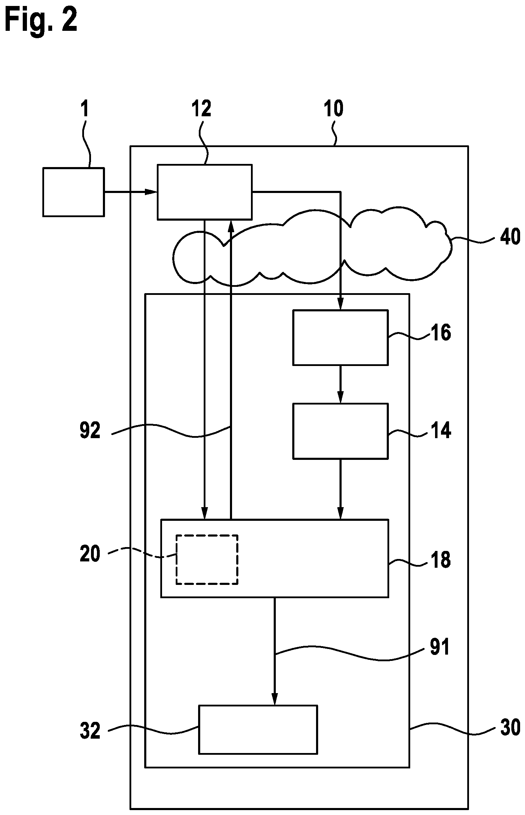

Ein System 10 gemäß einer Ausführungsform, in welchem die Datenspeichervorrichtung 14, die Anpassungsvorrichtung 16 und die Rechenvorrichtung 18 in dem mobilen Endgerät 30 integriert sind, ist in dem schematischen Blockdiagramm von Fig. 2 gezeigt.

Das mobile Endgerät 30 kann einen Prozessor und einen Datenspeicher aufweisen, wobei die Anpassungsvorrichtung 16 und/oder die Rechenvorrichtung 18 durch Software (z.B. eine App) realisiert sind, welche in dem Datenspeicher gespeichert ist und welche durch den Prozessor ausgeführt wird. Die Datenspeichervorrichtung 14 kann in den Datenspeicher des mobilen Endgeräts 30 integriert sein.

Wird der Vergleichs-Spannungswert durch die Erfassungsvorrichtung 12 bereitgestellt, welche in dem Fahrzeug integriert ist, kann der Vergleichs-Spannungswert drahtgebunden, jedoch bevorzugt drahtlos, von der Erfassungsvorrichtung 12 zu dem mobilen Endgerät 30 übermittelt werden, beispielsweise über mindestens einen Server 40 (z.B. eine Servercloud), welcher Teil des Systems 10 sein kann. Alle von der Erfassungsvorrichtung 12 an das mobile Endgerät 30 übermittelten Signale können von einer ein ersten, bevorzugt drahtlosen, Kommunikationsschnittstelle der Erfassungsvorrichtung 12 an eine zweite, bevorzugt drahtlose, Kommunikationsschnittstelle des mobilen Endgeräts 30 übermittelt werden.

Das mobile Endgerät 30 kann dazu ausgelegt oder eingerichtet sein (z.B. durch entsprechende Programmierung der vorgenannten App), dass als Reaktion auf eine Nutzereingabe ein Anfragesignal 92 erzeugt wird (z.B. durch die Rechenvorrichtung 18) und an die Erfassungsvorrichtung 12 übermittelt wird, z.B. über die Servercloud und/oder den mindestens einen Server 40. Die Erfassungsvorrichtung 12 kann dazu eingerichtet sein, als Reaktion auf das Anfragesignal 92 den aktuellen Spannungswert zu erfassen und diesen als den Vergleichs-Spannungswert an die Rechenvorrichtung 18 zu übermitteln. Auf diese Weise kann der Benutzer basierend auf dem entsprechend erzeugten und ausgegebenen Ausgabesignal 91 eine aktuelle Information über den aktuellen Zustand der Fahrzeugbatterie 1 erhalten, beispielsweise über eine Startfähigkeit.

Diese aktuelle Information über die Startfähigkeit der Fahrzeugbatterie 1 kann beispielsweise in einer Ampelform dargestellt werden (rot: "nicht startfähig", gelb: "es könnte Schwierigkeiten beim Starten der Fahrzeugbatterie geben", grün: "startfähig") oder dergleichen, wobei jede Farbe einem durch die Spannungsschwellwerte definierten Spannungsbereich entspricht.

Das mobile Endgerät 30 kann dazu ausgelegt oder eingerichtet sein (z.B. durch entsprechende Programmierung der vorgenannten App), dass der Benutzer ein in der Zukunft liegendes Datum indizieren kann, z.B. durch Eingabe des Datums oder einer Anzahl von Tagen, Stunden etc. ab dem aktuellen Zeitpunkt, woraufhin die Schätzungsvorrichtung 20 basierend auf dem indizierten Datum einen Spannungswert der Spannung an Bord des Fahrzeugs als einen Schätzungs-Spannungswert vorhersagt und diesen Schätzungs-Spannungswert der Rechenvorrichtung 18 bereitstellt, basierend auf welchem durch die Rechenvorrichtung 18 das Ausgabesignal 91 erzeugt wird.

Plant der Benutzer eine längere Reise etwa in zehn Tagen, kann er diesen Zeitraum indizieren und basierend auf dem entsprechend erzeugten Ausgabesignal 91 durch die Ausgabevorrichtung 32 eine Information über den prognostizierten Zustand der Fahrzeugbatterie 1 erhalten. Beispielsweise kann prognostiziert werden, dass die Fahrzeugbatterie 1 in zehn Tagen nicht startfähig sein wird.

Optional kann zusätzlich, wie im Voranstehenden beschrieben, der aktuelle Zustand der Fahrzeugbatterie 1 bestimmt und an der Ausgabevorrichtung 32 eine Information darüber ausgegeben werden. Beispielsweise könnte der Benutzer eine Information erhalten, dass die Fahrzeugbatterie 1 aktuell startfähig ist.

Die Schätzungsvorrichtung 20 kann auch dazu ausgelegt oder eingerichtet sein, basierend auf den Spannungsschwellwerten in der Datenspeichervorrichtung 14 zu prognostizieren, bis zu welchem Tag die Fahrzeugbatterie 1 startfähig sein wird. Somit kann dem Benutzer durch die Ausgabevorrichtung 32 eine Information darüber ausgegeben werden, wann er das Fahrzeug spätestens wieder benützen muss, um die Fahrzeugbatterie 1 startfähig zu halten. Das mobile Endgerät 30 kann dazu ausgelegt sein, dem Benutzer hierzu basierend auf dem aktuellen Spannungswert konkrete Hinweise zu geben, beispielsweise wie viele Kilometer er mit dem Fahrzeug mindestens fahren sollte und dergleichen mehr.

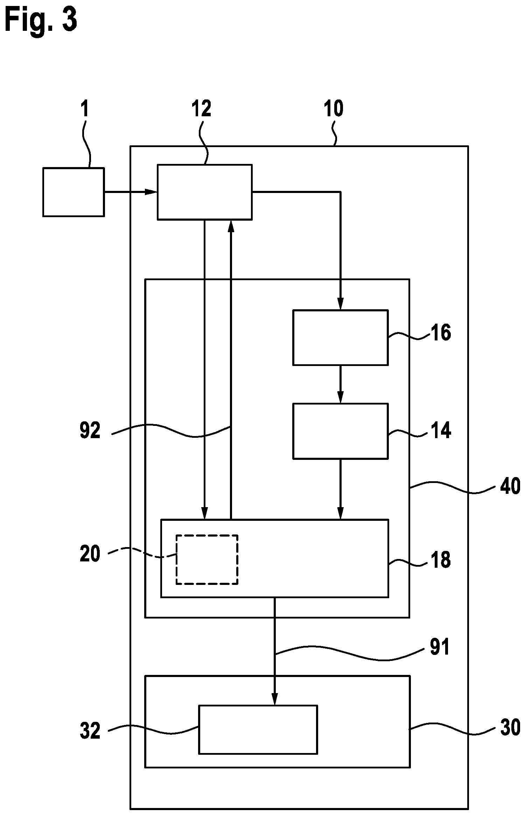

Fig. 3 zeigt ein schematisches Blockdiagramm eines Systems 10 gemäß einer weiteren Variante des Systems 10 aus Fig. 1. Bei dem in Fig. 3 dargestellten System sind die Datenspeichervorrichtung 14, die Anpassungsvorrichtung 16 und die Rechenvorrichtung 18 (optional mit der Schätzungsvorrichtung 20) durch mindestens einen Server 40 realisiert, z.B. cloudbasiert. Die Erfassungsvorrichtung 12 ist vorteilhaft als eine Telematikeinheit oder als Teil einer Telematikeinheit ausgebildet, welche in dem Fahrzeug installiert ist. Die Erfassungsvorrichtung 12 oder die Telematikeinheit können über eine drahtlose Kommunikationsschnittstelle, z.B. über eine Mobilfunkschnittstelle, verfügen oder mit einer solchen verbunden sein, über welche Daten von der Erfassungsvorrichtung 12 an den Server 40 zur Verarbeitung durch die Anpassungsvorrichtung 16 und die Rechenvorrichtung 18 übermittelbar sind und übermittelt werden. Die Erfassungsvorrichtung 12 oder die Telematikeinheit können dazu beispielsweise eine Mobilfunk-SIM-Karte aufweisen.

Wird das Fahrzeug beispielsweise in einer Tiefgarage geparkt, kann es dazu kommen, dass die Erfassungsvorrichtung 12 aufgrund einer Abschirmung des Mobilfunknetzes in der Tiefgarage keine aktuell erfassten Spannungswerte an den Server 40 übermitteln kann. In diesem Fall kann, wie im Vorstehenden beschrieben, vorgesehen sein, dass die Schätzungsvorrichtung 20 der Rechenvorrichtung 18 einen geschätzten aktuellen Spannungswert (oder Schätzungs-Spannungswert) als den Vergleich-Spannungswert bereitstellt.

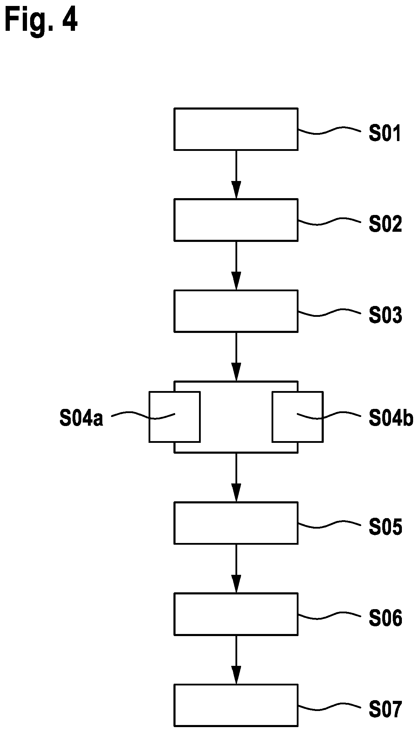

Fig. 4 zeigt ein schematisches Flussdiagramm zum Erläutern eines Verfahrens zum Bestimmen eines aktuellen und/oder eines prognostizierten Zustands einer Fahrzeugbatterie. Das Verfahren gemäß Fig. 4 ist durch das erfindungsgemäße System ausführbar und ist gemäß allen mit Bezug auf das erfindungsgemäße System beschriebenen Varianten und Modifikationen anpassbar und umgekehrt.

In einem Schritt S01 wird mindestens ein Spannungsschwellwert bereitgestellt, etwa wie im Voranstehenden mit Bezug auf die Datenspeichervorrichtung 14 beschrieben. Bevorzugt werden mehrere Spannungsschwellwerte bereitgestellt, beispielsweise, bezogen auf eine Fahrzeugbatterie 1 mit Nominalspannung von 12 Volt:
- 12.1 Volt bis 12.3 Volt: Fahrzeugbatterie in gutem Zustand;
- 11.9 Volt bis 12.1 Volt: Fahrzeugbatterie in akzeptablem Zustand;
- 11.5 Volt bis 11.9 Volt: Fahrzeugbatterie in bedenklichem Zustand; und
- Unter 11.5 Volt: Fahrzeugbatterie nicht startfähig.

Alternativ können, bezogen auf eine Maximalspannung einer soeben hergestellten oder soeben in das Fahrzeug eingebauten Fahrzeugbatterie 1, die Spannungsschwellwerte als Prozentsätze der Maximalspannung bereitgestellt werden.

In mehreren Schritten S02 wird ein jeweils aktueller Ruhezustand-Spannungswert einer Spannung an Bord des Fahrzeugs, welche auf die Fahrzeugbatterie 1 des Fahrzeugs zurückgeht, während mindestens eines Ruhezustands des Fahrzeugs erfasst, wenn, bevorzugt genau dann wenn, eine vorbestimmte Ruhezustandsbedingung erfüllt ist, wobei in dem Ruhezustand des Fahrzeugs ein Motor des Fahrzeugs ausgeschaltet ist. Das jeweilige Erfassen S02 kann z.B. erfolgen, und die Ruhezustandsbedingung kann so gewählt sein, wie im Voranstehenden mit Bezug auf die Erfassungsvorrichtung 12 beschrieben.

In einem Schritt S03 erfolgt ein Anpassen des mindestens einen Spannungsschwellwerts basierend auf den erfassten Ruhezustand-Spannungswerten, wobei bei dem Anpassen S03 nur solche der erfassten Ruhezustand-Spannungswerte berücksichtigt werden, welche eine vorbestimmte Verwertungsbedingung erfüllen, etwa wie im Voranstehenden mit Bezug auf die Anpassungsvorrichtung 16 und die dort beschriebenen möglichen Verwertungsbedingungen beschrieben.

In einem Schritt S04a wird ein aktueller Spannungswert erfasst und als Vergleichs-Spannungswert bereitgestellt, etwa wie im Voranstehenden mit Bezug auf die Erfassungsvorrichtung 12 beschrieben. In einem Schritt S04b wird, alternativ oder zusätzlich zu dem Schritt S04a, ein Schätzungs-Spannungswert vorhergesagt, etwa wie im Voranstehenden mit Bezug auf die Schätzungsvorrichtung 20 beschrieben, und als Vergleichs-Spannungswert bereitgestellt.

In einem Schritt S05 wird der bereitgestellte Vergleichs-Spannungswert mit dem mindestens einen Spannungsschwellwert verglichen. Insbesondere wird für das Vergleichen S05 der mindestens eine ursprünglich bereitgestellte Spannungsschwellwert solange herangezogen (und besonders bevorzugt auch nur so lange), solange nicht in den Schritten S02 eine vorbestimmte Anzahl von Ruhezustand-Spannungswerten (z.B. zehn, zwanzig, dreißig oder sechzig) erfasst und/oder gemäß der Verwertungsbedingung berücksichtigt wurde. So kann sichergestellt werden, dass der mindestens eine vorbestimmte Spannungsschwellwert erst dann durch den mindestens einen angepassten Spannungsschwellwert ersetzt wird, wenn das Anpassen S03 auf einer ausreichenden Datenbasis basiert.

In einem Schritt S06 wird der aktuelle und/oder der prognostizierte Zustand der Fahrzeugbatterie basierend auf einem Ergebnis des Vergleichens bestimmt, etwa wie im Voranstehenden mit Bezug auf die Rechenvorrichtung 18 beschrieben.

In einem Schritt S07 wird ein Ausgabesignals 91 erzeugt und ausgegeben, welches den bestimmten aktuellen und/oder prognostizierten Zustand der Fahrzeugbatterie 1 indiziert.

Das Ausgabesignal 91 kann, etwa wie im Voranstehenden mit Bezug auf die Figuren 1 und 2 beschrieben, weiterverarbeitet werden, etwa durch ein mobiles Endgerät 30. Weiterhin kann ein Anfragesignal 92 erzeugt und verarbeitet werden, wie mit Bezug auf Fig. 2 erläutert wurde.

Obwohl die vorliegende Erfindung anhand bevorzugter Ausführungsbeispiele vorstehend beschrieben wurde, ist sie darauf nicht beschränkt, sondern auf vielfältige Art und Weise modifizierbar. Insbesondere lässt sich die Erfindung in mannigfaltiger Weise verändern oder modifizieren, ohne vom Kern der Erfindung abzuweichen.

Die Rechenvorrichtung 18 kann beispielsweise zusätzlich dazu eingerichtet sein, die erfassten Spannungswerte auszuwerten, um festzustellen, ob die Ruhespannung der Fahrzeugbatterie 1 nach einer Fahrt, oder einer vorbestimmten Anzahl von Fahrten, des Fahrzeugs über eine vorbestimmte Mindestentfernung (z.B. 50 km) Spannungswerte oberhalb eines vorbestimmten Spannungsschwellwerts annimmt, z.B. oberhalb einer Nominalspannung der Fahrzeugbatterie, beispielsweise 12 Volt. Ist dies nicht der Fall, oder ist dies bei mindestens einer vorbestimmten Anzahl von solchen Fahrten über die vorbestimmte Mindestentfernung nicht der Fall, so kann die Rechenvorrichtung 18 daraus auf eine Sulfatierung, d.h. Alterung, oder einen anderen Defekt der Fahrzeugbatterie 1 schließen und kann dementsprechend das Ausgabesignal 91 derart erzeugen, dass das Ausgabesignal 91 indiziert, dass die Fahrzeugbatterie 1 ausgetauscht werden sollte.

Die Rechenvorrichtung 18 kann außerdem zusätzlich dazu eingerichtet sein, zu erfassen, dass die Ruhespannung der Fahrzeugbatterie 1 zwar nach einer Fahrt über die vorbestimmte Mindestentfernung über einen vorbestimmten Spannungsschwellwert ansteigt, dass die Ruhespannung jedoch innerhalb einer vorbestimmten Zeitspanne wieder unter diesen Spannungsschwellwert, oder unter einen niedrigeren Spannungsschwellwert absinkt. In diesem Fall kann die Rechenvorrichtung 18 so eingerichtet sein, das Ausgabesignal 91 derart zu erzeugen, dass das Ausgabesignal 91 indiziert, dass die Fahrzeugbatterie 1 nicht dazu in der Lage ist, die Spannung zu halten, und repariert oder ausgetauscht werden sollte. Auf diese Weise kann insbesondere eine Batteriealterung festgestellt werden.

Das Ausgabesignal 91 kann mit zusätzlichen Informationen angereichert werden, beispielsweise Tipps zur besseren Pflege der Fahrzeugbatterie, eine Analyse des Fahrverhaltens und/oder eine Korrelation mit Umgebungsfaktoren, Vorschläge für einen Batteriewechsel und/oder eine Reparatur und dergleichen mehr. Das Ausgabesignal kann eine Datenspeicherung in einer Datenbank bewirken, welche Dienstleistern wie z.B. Reparaturwerkstätten, Batterieherstellern, Ersatzteillieferanten, Flottenbetreibern, Pannendienstanbietern, Versicherungsfirmen etc. zur weiteren Datenverarbeitung zur Verfügung steht.

## Patentansprüche

1. System (10) zum Bestimmen eines aktuellen und/oder prognostizierten Zustands einer Fahrzeugbatterie (1) eines Fahrzeugs, mit:
einer Erfassungsvorrichtung (12), mittels welcher ein aktueller Spannungswert einer Spannung an Bord des Fahrzeugs, welche auf die Fahrzeugbatterie (1) des Fahrzeugs zurückgeht, erfassbar ist;
wobei die Erfassungsvorrichtung (12) dazu eingerichtet ist, mehrmals einen jeweils aktuellen Ruhezustand-Spannungswert während mindestens eines Ruhezustands des Fahrzeugs zu erfassen, wenn eine vorbestimmte Ruhezustandsbedingung erfüllt ist; wobei in dem Ruhezustand des Fahrzeugs ein Motor des Fahrzeugs ausgeschaltet ist;
einer Datenspeichervorrichtung (14), in welcher mindestens ein Spannungsschwellwert hinterlegt sind;
einer Anpassungsvorrichtung (16), welche dazu ausgelegt ist, basierend auf den erfassten Ruhezustand-Spannungswerten den mindestens einen Spannungsschwellwert in der Datenspeichervorrichtung (14) anzupassen, wobei nur solche der erfassten Ruhezustand-Spannungswerte berücksichtigt werden, welche eine vorbestimmte Verwertungsbedingung erfüllen; und
einer Rechenvorrichtung (18), welche dazu ausgelegt ist, basierend auf einem Vergleich eines bereitgestellten Vergleichs-Spannungswertes, der durch den aktuell erfassten Spannungswert oder durch einen Schätzungs-Spannungswert bereitgestellt ist, mit zumindest dem mindestens einen Spannungsschwellwert den aktuellen oder prognostizierten Zustand der Fahrzeugbatterie (1) zu bestimmen und ein Ausgabesignal (91) auszugeben, welches den bestimmten aktuellen und/oder prognostizierten Zustand der Fahrzeugbatterie (1) indiziert.

2. System (10) nach Anspruch 1,
wobei die Erfassungsvorrichtung (12) außerdem dazu ausgelegt ist, der Rechenvorrichtung (18) einen aktuellen Spannungswert als den Vergleichs-Spannungswert bereitzustellen.

3. System (10) nach Anspruch 1 oder 2,
mit einer Schätzungsvorrichtung (20), welche dazu ausgelegt ist, mindestens einen zukünftigen Spannungswert als einen Schätzungs-Spannungswert vorherzusagen und der Rechenvorrichtung (18) den Schätzungs-Spannungswert als den Vergleichs-Spannungswert bereitzustellen.

4. System (10) nach einem der Ansprüche 1 bis 3,
wobei die Erfassungsvorrichtung (12) an eine Diagnose-Schnittstelle des Fahrzeugs anschließbar oder angeschlossen ist und dazu eingerichtet ist, an der On-Board-Diagnose-Schnittstelle einen aktuellen Spannungswert einer Bordnetzspannung des Fahrzeugs zu erfassen;
und/oder
wobei die Erfassungsvorrichtung (12) dazu eingerichtet ist, einen aktuellen Spannungswert einer Klemmenspannung der Fahrzeugbatterie (1) direkt an Batteriepolen der Fahrzeugbatterie (1) zu erfassen.

5. System (10) nach einem der Ansprüche 1 bis 4,
wobei das Ausgabesignal (91) außerdem auf mindestens einer der folgenden Informationen basiert:
- eine Information über einen Batterietyp der Fahrzeugbatterie (1);
- eine Information über einen Fahrzeugtyp des Fahrzeugs;
- eine Information über eine Historie des Fahrzeugs;
- eine Information über eine Ausstattung des Fahrzeugs.

6. System (10) nach einem der Ansprüche 1 bis 5,
wobei die vorbestimmte Ruhezustandsbedingung eine der folgenden Bedingungen ist oder aufweist, oder eine Verknüpfung von mindestens zwei der folgenden Bedingungen ist oder aufweist:
- seit einem Ende der letzten Fahrt mit dem Fahrzeug ist mindestens ein erster vorbestimmter Zeitraum vergangen;
- eine vorbestimmte oder eingestellte Uhrzeit entspricht der aktuellen Uhrzeit;
- in einem zurückliegenden zweiten vorbestimmten Zeitraum wurde kein Ruhezustand-Spannungswert erfasst.

7. System (10) nach einem der Ansprüche 1 bis 6,
wobei die vorbestimmte Verwertungsbedingung eine der folgenden Bedingungen ist oder aufweist, oder eine Verknüpfung von mindestens zwei der folgenden Bedingungen ist oder aufweist:
- in einem zurückliegenden dritten vorbestimmten Zeitraum vor dem Erfassen des Spannungswerts wurde mindestens eine vorbestimmte Entfernung mit dem Fahrzeug zurückgelegt;
- in einem zurückliegenden vierten Zeitraum vor dem Erfassen des Spannungswerts wurde innerhalb einer einzelnen Fahrt über mindestens einen fünften vorbestimmten Zeitraum mit einer Geschwindigkeit oberhalb eines vorbestimmten Geschwindigkeitsschwellwerts gefahren;
- - in einem zurückliegenden sechsten Zeitraum vor dem Erfassen des Spannungswerts wurde innerhalb einer einzelnen Fahrt über mindestens einen siebten vorbestimmten Zeitraum hinweg mit einer Drehzahl oberhalb eines vorbestimmten Drehzahl-Schwellenwerts gefahren.

8. System (10) nach einem der Ansprüche 1 bis 7,
umfassend ein mobiles und/oder internet-fähiges Endgerät (30) mit einer Ausgabevorrichtung (32), welche dazu ausgelegt ist, basierend auf dem Ausgabesignal (91) eine grafische, akustische und/oder haptische Ausgabe zu erzeugen.

9. System (10) nach einem der Ansprüche 1 bis 8,
wobei die Rechenvorrichtung (18) zusätzlich dazu eingerichtet ist, die erfassten Spannungswerte auszuwerten, um festzustellen, ob die Ruhespannung der Fahrzeugbatterie (1) nach einer Fahrt, oder einer vorbestimmten Anzahl von Fahrten des Fahrzeugs über eine vorbestimmte Mindestentfernung, Spannungswerte oberhalb eines vorbestimmten Spannungsschwellwerts annimmt; und
wobei, falls dies nicht der Fall ist, oder falls dies bei mindestens einer vorbestimmten Anzahl von solchen Fahrten über die vorbestimmte Mindestentfernung nicht der Fall ist, die Rechenvorrichtung (18) daraus auf einen Defekt der Fahrzeugbatterie (1) schließt und dementsprechend das Ausgabesignal (91) derart erzeugt, dass das Ausgabesignal (91) indiziert, dass die Fahrzeugbatterie (1) ausgetauscht werden sollte.

10. Verfahren zum Bestimmen eines aktuellen und/oder prognostizierten Zustands einer Fahrzeugbatterie (1) eines Fahrzeugs, mit den Schritten:
Bereitstellen (S01) mindestens eines Spannungsschwellwerts;
Mehrmaliges Erfassen (S02) eines jeweils aktuellen Ruhezustand-Spannungswerts einer Spannung an Bord des Fahrzeugs, welche auf die Fahrzeugbatterie (1) des Fahrzeugs zurückgeht, während mindestens eines Ruhezustands des Fahrzeugs, wenn eine vorbestimmte Ruhezustandsbedingung erfüllt ist, wobei in dem Ruhezustand des Fahrzeugs ein Motor des Fahrzeugs ausgeschaltet ist;
Anpassen (S03) des Spannungsschwellwerts basierend auf den erfassten Ruhezustand-Spannungswerten, wobei nur solche der erfassten Ruhezustand-Spannungswerte berücksichtigt werden, welche eine vorbestimmte Verwertungsbedingung erfüllen;
Erfassen (S04a) eines aktuellen Spannungswerts als Vergleichs-Spannungswert und/oder Vorhersagen (S04b) eines Schätzungs-Spannungswerts als Vergleichs-Spannungswert;
Vergleichen (S05) des Vergleichs-Spannungswerts mit zumindest dem mindestens einen Spannungsschwellwert;
Bestimmen (S06) des aktuellen und/oder prognostizierten Zustands der Fahrzeugbatterie basierend auf einem Ergebnis des Vergleichens; und
Ausgeben (S07) eines Ausgabesignals (91), welches den bestimmten aktuellen und/oder prognostizierten Zustand der Fahrzeugbatterie (1) indiziert.

11. Verfahren nach Anspruch 10,
wobei die vorbestimmte Ruhezustandsbedingung eine der folgenden Bedingungen ist oder aufweist, oder eine Verknüpfung von mindestens zwei der folgenden Bedingungen ist oder aufweist:
- seit einem Ende der letzten Fahrt mit dem Fahrzeug ist mindestens ein erster vorbestimmter Zeitraum vergangen;
- eine vorbestimmte oder eingestellte Uhrzeit entspricht der aktuellen Uhrzeit;
- in einem zurückliegenden zweiten vorbestimmten Zeitraum wurde kein Ruhezustand-Spannungswert erfasst.

12. Verfahren nach Anspruch 10 oder 11,
wobei die vorbestimmte Verwertungsbedingung eine der folgenden Bedingungen ist oder aufweist, oder eine Verknüpfung von mindestens zwei der folgenden Bedingungen ist oder aufweist:
- in einem zurückliegenden dritten vorbestimmten Zeitraum wurde mindestens eine vorbestimmte Entfernung mit dem Fahrzeug zurückgelegt;
- in einem zurückliegenden vierten Zeitraum vor dem Erfassen des Spannungswerts wurde innerhalb einer einzelnen Fahrt über mindestens einen fünften vorbestimmten Zeitraum mit einer Geschwindigkeit oberhalb einem vorbestimmten Geschwindigkeitsschwellwert gefahren;
- in einem zurückliegenden sechsten Zeitraum vor dem Erfassen des Spannungswerts wurde innerhalb einer einzelnen Fahrt über mindestens einen siebten vorbestimmten Zeitraum hinweg mit einer Drehzahl oberhalb eines vorbestimmten Drehzahl-Schwellenwerts gefahren.

## Claims

1. System (10) for determining a present and/or forecast state of a vehicle battery (1) of a vehicle, having:
a recording apparatus (12), by means of which a present voltage value of a voltage on board the vehicle, which voltage traces back to the vehicle battery (1) of the vehicle, can be recorded;
wherein the recording apparatus (12) is configured to repeatedly record a particular present idle-state voltage value during at least one idle state of the vehicle if a predetermined idle-state condition is satisfied, an engine of the vehicle being switched off in the idle state of the vehicle;
a data storage apparatus (14), in which at least one voltage threshold value is stored;
an adapting apparatus (16), which is designed to take the recorded idle-state voltage values as a basis for adapting the at least one voltage threshold value in the data storage apparatus (14), only those recorded idle-state voltage values that satisfy a predetermined utilization condition being taken into consideration; and
a computing apparatus (18), which is designed to take a comparison of a provided comparison voltage value, which is provided by the currently recorded voltage value or by an estimate voltage value, with at least the at least one voltage threshold value as a basis for determining the present or forecast state of the vehicle battery (1) and to output an output signal (91) that indicates the determined present and/or forecast state of the vehicle battery (1).

2. System (10) according to Claim 1,
wherein the recording apparatus (12) is additionally designed to provide the computing apparatus (18) with a present voltage value as the comparison voltage value.

3. System (10) according to Claim 1 or 2,
having an estimating apparatus (20) that is designed to predict at least one future voltage value as an estimate voltage value and to provide the computing apparatus (18) with the estimate voltage value as the comparison voltage value.

4. System (10) according to one of Claims 1 to 3,
wherein the recording apparatus (12) can be connected or is connected to a diagnosis interface of the vehicle and is configured to record a present voltage value of a vehicle electrical system voltage of the vehicle at the onboard diagnosis interface;
and/or
wherein the recording apparatus (12) is configured to record a present voltage value of a terminal voltage of the vehicle battery (1) directly at battery terminals of the vehicle battery (1).

5. System (10) according to one of Claims 1 to 4, wherein the output signal (91) is additionally based on at least one of the following pieces of information:
- information about a battery type of the vehicle battery (1);
- information about a vehicle type of the vehicle;
- information about a history of the vehicle;
- information about features of the vehicle.

6. System (10) according to one of Claims 1 to 5,
wherein the predetermined idle-state condition is or comprises one of the following conditions, or is or comprises a combination of at least two of the following conditions:
- at least a first predetermined period has elapsed since the end of the last journey with the vehicle;
- a predetermined or set time corresponds to the present time;
- no idle-state voltage value has been recorded in a past second predetermined period.

7. System (10) according to one of Claims 1 to 6,
wherein the predetermined utilization condition is or comprises one of the following conditions, or is or comprises a combination of at least two of the following conditions:
- at least one predetermined distance has been covered with the vehicle in a past third predetermined period before the voltage value was recorded;
- the vehicle has travelled at a speed above a predetermined speed threshold value over at least a fifth predetermined period within a single journey in a past fourth period before the voltage value was recorded;
- the vehicle has travelled with an engine speed above a predetermined engine speed threshold value over at least a seventh predetermined period within a single journey in a past sixth period before the voltage value was recorded.

8. System (10) according to one of Claims 1 to 7, comprising a mobile and/or Internet-capable terminal (30) having an output apparatus (32) that is designed to take the output signal (91) as a basis for producing a graphical, audible and/or haptic output.

9. System (10) according to one of Claims 1 to 8,
wherein the computing apparatus (18) is additionally configured to evaluate the recorded voltage values in order to establish whether the idle voltage of the vehicle battery (1) assumes voltage values above a predetermined voltage threshold value after a journey, or a predetermined number of journeys, by the vehicle over a predetermined minimum distance; and
wherein, if this is not the case, or if this is not the case for at least a predetermined number of such journeys over the predetermined minimum distance, the computing apparatus (18) infers a fault in the vehicle battery (1) therefrom and accordingly generates the output signal (91) in such a way that the output signal (91) indicates that the vehicle battery (1) should be replaced.

10. Method for determining a present and/or forecast state of a vehicle battery (1) of a vehicle, having the steps of:
providing (S01) at least one voltage threshold value;
repeatedly recording (S02) a particular present idle-state voltage value of a voltage on board the vehicle, which voltage traces back to the vehicle battery (1) of the vehicle, during at least one idle state of the vehicle if a predetermined idle-state condition is satisfied, an engine of the vehicle being switched off in the idle state of the vehicle;
adapting (S03) the voltage threshold value on the basis of the recorded idle-state voltage values, only those recorded idle-state voltage values that satisfy a predetermined utilization condition being taken into consideration;
recording (S04a) a present voltage value as the comparison voltage value and/or predicting (S04b) an estimate voltage value as the comparison voltage value;
comparing (S05) the comparison voltage value with at least the at least one voltage threshold value;
determining (S06) the present and/or forecast state of the vehicle battery on the basis of a result of the comparison; and
outputting (S07) an output signal (91) that indicates the determined present and/or forecast state of the vehicle battery (1).

11. Method according to Claim 10,
wherein the predetermined idle-state condition is or comprises one of the following conditions, or is or comprises a combination of at least two of the following conditions:
- at least a first predetermined period has elapsed since the end of the last journey with the vehicle;
- a predetermined or set time corresponds to the present time;
- no idle-state voltage value has been recorded in a past second predetermined period.

12. Method according to Claim 10 or 11,
wherein the predetermined utilization condition is or comprises one of the following conditions, or is or comprises a combination of at least two of the following conditions:
- at least one predetermined distance has been covered with the vehicle in a past third predetermined period;
- the vehicle has travelled at a speed above a predetermined speed threshold value over at least a fifth predetermined period within a single journey in a past fourth period before the voltage value was recorded;
- the vehicle has travelled with an engine speed above a predetermined engine speed threshold value over at least a seventh predetermined period within a single journey in a past sixth period before the voltage value was recorded.

## Revendications

1. Système (10) permettant de déterminer un état actuel et/ou prévu d'une batterie de véhicule (1) d'un véhicule, comprenant :
un dispositif de détection (12) qui permet de détecter une valeur de tension actuelle d'une tension à bord du véhicule et qui provient de la batterie de véhicule (1) du véhicule ;
dans lequel le dispositif de détection (12) est conçu pour détecter à plusieurs reprises une valeur de tension d'état de repos respectivement actuelle pendant au moins un état de repos du véhicule si une condition d'état de repos prédéterminée est satisfaite ; dans lequel un moteur du véhicule est coupé à l'état de repos du véhicule ;
un dispositif de stockage de données (14) dans lequel au moins une valeur seuil de tension est enregistrée ;
un dispositif d'adaptation (16) qui est conçu, sur la base des valeurs de tension d'état de repos détectées, pour adapter ladite au moins une valeur seuil de tension dans le dispositif de stockage de données (14), dans lequel sont prises en compte seules les valeurs de tension d'état de repos qui satisfont une condition d'exploitation prédéterminée ; et
un dispositif de calcul (18) qui est conçu, sur la base d'une valeur de tension de comparaison fournie qui est fournie par la valeur de tension détectée actuellement ou par une valeur de tension estimée, avec au moins ladite au moins une valeur seuil de tension, pour déterminer l'état actuel ou prévu de la batterie de véhicule (1) et pour délivrer un signal de sortie (91) qui indique l'état actuel et/ou prévu de la batterie de véhicule (1).

2. Système (10) selon la revendication 1, dans lequel le dispositif de détection (12) est en outre conçu pour fournir au dispositif de calcul (18) une valeur de tension actuelle en tant que valeur de tension de comparaison.

3. Système (10) selon la revendication 1 ou 2, comprenant un dispositif d'estimation (20) qui est conçu pour prédire au moins une valeur de tension future en tant que valeur de tension estimée, et pour fournir au dispositif de calcul (18) la valeur de tension estimée en tant que valeur de tension de comparaison.

4. Système (10) selon l'une quelconque des revendications 1 à 3,
dans lequel le dispositif de détection (12) peut être ou est connecté à une interface de diagnostic du véhicule, et est conçu pour détecter au niveau de l'interface de diagnostic de bord une valeur de tension actuelle d'une tension de réseau de bord du véhicule ; et/ou
dans lequel le dispositif de détection (12) est conçu pour détecter une valeur de tension actuelle d'une tension aux bornes de la batterie de véhicule (1) directement au niveau des pôles de batterie de la batterie de véhicule (1).

5. Système (10) selon l'une quelconque des revendications 1 à 4, dans lequel le signal de sortie (91) est en outre basé sur au moins l'une des informations suivantes :
- une information concernant un type de batterie de la batterie de véhicule (1) ;
- une information concernant un type de véhicule du véhicule ;
- une information concernant un historique du véhicule ;
- une information concernant un équipement du véhicule.

6. Système (10) selon l'une quelconque des revendications 1 à 5, dans lequel la condition d'état de repos prédéterminée est ou présente l'une des conditions suivantes, ou est ou présente une association d'au moins deux des conditions suivantes :
- depuis la fin du dernier déplacement avec le véhicule, au moins un premier laps de temps prédéterminé s'est écoulé ;
- une heure prédéterminée ou réglée correspond à l'heure actuelle ;
- aucune valeur de tension d'état de repos n'a été détectée au cours d'un deuxième laps de temps prédéterminé antérieur.

7. Système (10) selon l'une quelconque des revendications 1 à 6, dans lequel la condition d'exploitation prédéterminée est ou présente l'une des conditions suivantes ou est ou présente une association d'au moins deux des conditions suivantes :
- dans un troisième laps de temps prédéterminé antérieur avant la détection de la valeur de tension, le véhicule a parcouru au moins une distance prédéterminée ;
- dans un quatrième laps de temps antérieur avant la détection de la valeur de tension, au cours d'un seul déplacement, pendant au moins un cinquième laps de temps prédéterminé, une vitesse supérieure à une valeur seuil de vitesse prédéterminée a été atteinte ;
- dans un sixième laps de temps antérieur avant la détection de la valeur de tension, au cours d'un seul déplacement, pendant au moins un septième laps de temps prédéterminé, une vitesse de rotation supérieure à une valeur seuil de vitesse de rotation prédéterminée a été atteinte.

8. Système (10) selon l'une quelconque des revendications 1 à 7, comprenant un terminal (30) mobile et/ou compatible internet pourvu d'un dispositif de sortie (32) qui est conçu pour générer une sortie graphique, acoustique et/ou haptique sur la base du signal de sortie (91).

9. Système (10) selon l'une quelconque des revendications 1 à 8,
dans lequel le dispositif de calcul (18) est en outre conçu pour évaluer les valeurs de tension détectées afin de constater si la tension de repos de la batterie de véhicule (1) après un déplacement, ou un nombre prédéterminé de déplacements, du véhicule sur une distance minimale prédéterminée, adopte des valeurs de tension supérieures à une valeur seuil de tension prédéterminée ; et
dans lequel, si ce n'est pas le cas, et si ce n'est pas le cas pour au moins un nombre prédéterminé de ces déplacements sur la distance minimale prédéterminée, le dispositif de calcul (18) en conclut à un défaut de la batterie de véhicule (1) et génère par conséquent le signal de sortie (91) de telle sorte que le signal de sortie (91) indique que la batterie de véhicule (1) doit être remplacée.

10. Procédé permettant de déterminer un état actuel et/ou prévu d'une batterie de véhicule (1) d'un véhicule, comprenant les étapes consistant à :
fournir (S01) au moins une valeur seuil de tension ;
détecter (S02) à plusieurs reprises une valeur de tension d'état de repos respectivement actuelle d'une tension à bord du véhicule provenant de la batterie de véhicule (1) du véhicule, pendant au moins un état de repos du véhicule, si une condition d'état de repos prédéterminée est satisfaite, dans lequel un moteur du véhicule est coupé à l'état de repos du véhicule ;
adapter (S03) la valeur seuil de tension sur la base des valeurs de tension d'état de repos détectées, dans lequel sont prises en compte seules les valeurs de tension d'état de repos détectées qui satisfont une condition d'exploitation prédéterminée ;
détecter (S04a) une valeur de tension actuelle en tant que valeur de tension de comparaison et/ou prédire (S04b) une valeur de tension estimée en tant que valeur de tension de comparaison ;
comparer (S05) la valeur de tension de comparaison avec au moins ladite au moins une valeur seuil de tension ;
déterminer (S06) l'état actuel et/ou prévu de la batterie de véhicule sur la base d'un résultat de la comparaison ; et
délivrer (S07) un signal de sortie (91) qui indique l'état actuel et/ou prévu déterminé de la batterie de véhicule (1).

11. Procédé selon la revendication 10, dans lequel la condition d'état de repos prédéterminée est ou présente l'une des conditions suivantes, ou est ou présente une association d'au moins deux des conditions suivantes:
- depuis la fin du dernier déplacement avec le véhicule, au moins un premier laps de temps prédéterminé s'est écoulé ;
- une heure prédéterminée ou réglée correspond à l'heure actuelle ;
- aucune valeur de tension d'état de repos n'a été détectée au cours d'un deuxième laps de temps prédéterminé antérieur.

12. Procédé selon la revendication 10 ou 11, dans lequel la condition d'exploitation prédéterminée est ou présente l'une des conditions suivantes, ou est ou présente une association d'au moins deux des conditions suivantes :
- dans un troisième laps de temps prédéterminé antérieur, le véhicule a parcouru au moins une distance prédéterminée ;
- dans un quatrième laps de temps antérieur avant la détection de la valeur de tension, au cours d'un seul déplacement, pendant au moins un cinquième laps de temps prédéterminé, une vitesse supérieure à une valeur seuil de vitesse prédéterminée a été atteinte ;
- dans un sixième laps de temps antérieur avant la détection de la valeur de tension, au cours d'un seul déplacement, pendant au moins un septième laps de temps prédéterminé, une vitesse de rotation supérieure à une valeur seuil de vitesse de rotation prédéterminée a été atteinte.
